(19) Europäisches Patentamt
European Patent Office
Office européen des brevets

(11) Veröffentlichungsnummer: **0 405 407 A2**

(12) **EUROPÄISCHE PATENTANMELDUNG**

(21) Anmeldenummer: 90112050.1

(22) Anmeldetag: 25.06.90

(51) Int. Cl.⁵: **H03K 17/06**

(30) Priorität: 29.06.89 DE 3921433

(43) Veröffentlichungstag der Anmeldung:
02.01.91 Patentblatt 91/01

(84) Benannte Vertragsstaaten:
DE FR GB IT SE

(71) Anmelder: **Siemens Aktiengesellschaft
Wittelsbacherplatz 2
D-8000 München 2(DE)**

(72) Erfinder: **Tihanyi, Jenoe, Dr.Ing.
Hartelstrasse 6
D-8000 München 21(DE)**

(54) **Schaltungsanordnung zum Ansteuern eines MOSFET mit sourceseitiger Last.**

(57) Leistungs-MOSFETs (2), die als Sourcefolger betrieben werden, können durch eine "Bootstrap"Schaltungsanordnung angesteuert werden. Zwischen dem Drain- und dem Source-Anschluß des MOSFET (2) liegt dabei eine Reihenschaltung aus einer Diode (3) und einem Kondensator (4). Die Betriebsspannungsquelle, die mit dem Drain-Anschluß des MOSFET (2) verbunden ist, lädt den Kondensator (4) über die Diode (3) auf. Dieser kann sich nun, über die Drain-Source-Strecke eines durch einen Schalter (9) gesteuerten Depletion-MOSFET (5), in die Gate-Source-Kapazität des Leistungs-MOSFET (2) schnell entladen und ihn leitend steuern. Das am Source-Anschluß des MOSFET (2) ansteigende Potential verschiebt über den Kondensator (4) die Spannung am Gate-Anschluß des MOSFET (2) und hält ihn im leitenden Zustand. Der Depletion-MOSFET (5) begrenzt den Ruhestrom auf kleine Werte.

Die erfindungsgemäße Schaltungsanordnung wird angewandt in Smart FETs.

FIG 1

EP 0 405 407 A2

## SCHALTUNGSANORDNUNG ZUM ANSTEUERN EINES MOSFET MIT SOURCESEITIGER LAST.

Die Erfindung bezieht sich auf eine Schaltungsanordnung zum Ansteuern eines MOSFET mit einer Last, die zwischen Source-Anschluß und einem vorgegebenen festen Potential liegt, mit den Merkmalen:

a) der Drain-Anschluß des MOSFET ist mit einer Ausgangsklemme verbunden,

b) zwischen dem Gate-Anschluß des MOSFET und einem festen Potential liegt ein Schalter,

c) zwischen der Ausgangsklemme und dem Source-Anschluß des MOSFET liegt die Reihenschaltung aus einer Diode und einem Kondensator,

d) die Reihenschaltung von Diode und Kondensator ist mit einem Mittelabgriff versehen, der über einen Transistor mit dem Gate-Anschluß des MOSFET verbunden ist.

Eine solche Schaltungsanordnung ist beispielsweise im Buch "Siliconix VMOS Power FETs Design Catalog" (1979) S.4-6 beschrieben worden. Sie trägt dem Umstand Rechnung, daß das Source-Potential beim Einschalten des MOSFET mit sourceseitiger Last nicht konstant bleibt. Soll der MOSFET vollständig leitend gesteuert werden, muß gewährleistet sein, daß das Gate-Potential immer mindestens um die Einsatzspannung des MOSFET über dem Source-Potential liegt. Die Schaltungsanordnung macht vom sogenannten "Bootstrap" Gebrauch, bei dem im abgeschalteten Zustand des MOSFET ein Kondensator über eine Diode aufgeladen wird. Im eingeschalteten Zustand entlädt sich der Kondensator über einen Transistor in die Gate-Source-Kapazität und schaltet nun den MOSFET leitend. Das nun am Source-Anschluß des MOSFET ansteigende Potential verschiebt die Spannung am Gate-Anschluß des MOSFET über eben diesen Wert, so daß weiterhin ein sicheres Durchschal ten des MOSFET gewährleistet ist. Die verschiedenen Zustände der Schaltungsanordnung können z.B. durch einen Schalter oder einen Transistor bestimmt werden. Mit der bekannten Schaltung ist es möglich, auch ohne zusätzliche Spannung den MOSFET sicher im leitenden Zustand zu halten.

Vorteile dieser Schaltungsanordnung sind schnelles Ein- und Ausschalten. Ein Nachteil ist, daß im abgeschalteten Zustand ein relativ hoher Runestrom fließt. Dies ist durch die inverse Logik der Schaltungsanordnung bedingt, die zum Abschalten des MOSFET ein Schließen des Schalters fordert, über den dann der Ruhestrom fließt.

Der Erfindung liegt die Aufgabe zugrunde, eine Schaltungsanordnung der genannten Art so weiterzubilden, daß einerseits mit kleinem Aufwand im abgeschalteten Zustand ein möglichst geringer Ruhestrom fließt und andererseits ein schnelles Ein- und Ausschalten gewährleistet ist.

Diese Aufgabe wird gelöst durch die Merkmale:

e) zwischen Schalter und Gate-Anschluß liegt eine Stromquelle,

f) der Transistor ist ein Depletion-MOSFET,

g) zwischen Gate-Anschluß und Source-Anschluß des Depletion-MOSFET liegen Mittel, an denen ein Spannungsabfall erzeugt wird.

Die Erfindung wird anhand einer Prinzipschaltungsanordnung und zweier Ausführungsbeispiele in Verbindung mit FIG 1 bis FIG 3 näher erläutert.

Es zeigen:

FIG 1 eine Prinzipschaltung gemäß der Erfindung,

FIG 2 ein erstes praktisches Ausführungsbeispiel der Schaltungsanordnung,

FIG 3 ein zweites praktisches Ausführungsbeispiel als Halbbrücke.

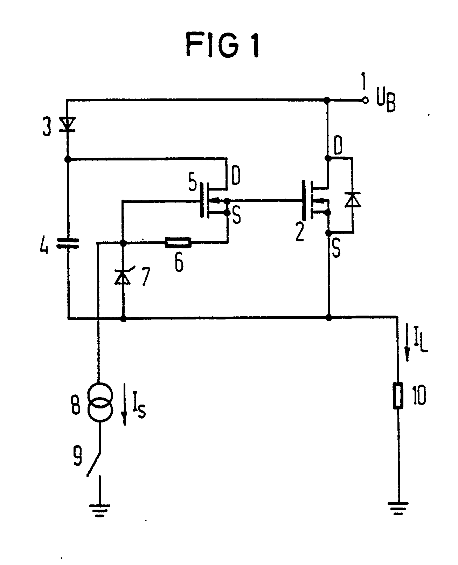

Die Schaltungsanordnung nach FIG 1 enthält einen LeistungsMOSFET 2, der als Source-Folger betrieben wird. Der Drain-Anschluß von Transistor 2 ist mit einer Ausgangsklemme 1 verbunden, an die eine Betriebsspannung $U_B$ anlegbar ist. Sourceseitig ist dem Transistor 2 eine Last 10 in Reihe geschaltet, die mit einem festen Potential verbunden ist. Dieses Potential kann z.B. das Massepotential sein. Im folgenden wird dieses Potential als Massepotential angenommen. Zwischen Ausgangsklemme 1 und dem Source-Anschluß von Transistor 2 ist die Reihenschaltung einer Diode 3 und eines Kondensators 4 angeschlossen. Sie ist mit einem Mittelabgriff versehen, der über die Drain-Source-Strecke eines Depletion-MOSFET 5 mit dem Gate-Anschluß des Transistors 2 verbunden ist, derart, daß der Source-Anschluß von Transistor 5 mit dem Gate-Anschluß von Transistor 2 und der Drain-Anschluß von Transistor 5 mit dem Mittelabgriff verbunden ist. Zwischen Gate-Anschluß und Source-Anschluß des Transistors 5 liegt ein Widerstand 6. Zwischen dem Gate-Anschluß des Transistors 5 und dem Source-Anschluß des Transistors 2 liegt eine Zenerdiode 7. Der Gate-Anschluß des Transistors 2 ist über den Widerstand 6 durch eine Reihenschaltung aus einer Stromquelle 8 und einem Schalters 9 mit Masse verbunden.

Im abgeschalteten Zustand des MOSFET 2 ist der Schalter 9 geschlossen und die Transistoren 2 und 5 sperren. Über die Diode 3 wird der Kondensator 4 aufgeladen. Da der Schalter 9 geschlossen ist, liegt am Gate-Anschluß von Transistor 5 ein niedrigeres Potential als an dessen Source-Anschluß und sperrt ihn somit. Dies bewirkt, daß der Widerstand der Drain-Source-Strecke sehr hoch und damit der Ruhestrom sehr gering ist.

Soll der Transistor 2 eingeschaltet werden, so muß der Schalter 9 geöffnet werden. Dadurch erhöht sich das Potential am Gate-Anschluß des Transistors 5 und schaltet ihn leitend.

Der Widerstand der Drain-Source-Strecke des Transistors 5 ist nun sehr gering, und der Kondensator 4 entlädt sich sehr schnell in die Gate-Source-Kapazität des Transistors 2. Der Transistor 2 wird leitend, und es kann ein Strom $I_L$ von der Klemme 1 durch die Last 10 nach Masse fließen. Das dadurch am Source-Anschluß von Transistor 2 ansteigende Potential verschiebt über den Kondensator 4 und den Transistor 5 die Spannung am Gate-Anschluß von Transistor 2. Dieser Spannungshub ist gleich der Spannung am Source-Anschluß von Transistor 2 abzüglich der Durchlaßspannung von Transistor 5 und gewährt, daß der Transistor 2 sicher leitend bleibt.

Soll der Transistor 2 abgeschaltet werden, so muß der Schalter 9 wieder geschlossen werden. Dadurch fließt ein Strom $I_S$, der die Gate-Source-Kapazität von Transistor 2 entlädt und diesen sperrt. Die Stromquelle begrenzt den Entladestrom $I_S$, so daß die Transistoren 2 und 5 nicht durch zu hohe Entladeströme zerstört werden können. Der Spannungsabfall am Widerstand 6 bewirkt ein Sperren von Transistor 5, und der Kondensator 4 wird wieder über die Diode 3 aufgeladen. Die Zenerdiode 7 schützt den Transistor 2 vor zu hohen positiven oder negativen Gatespannungen.

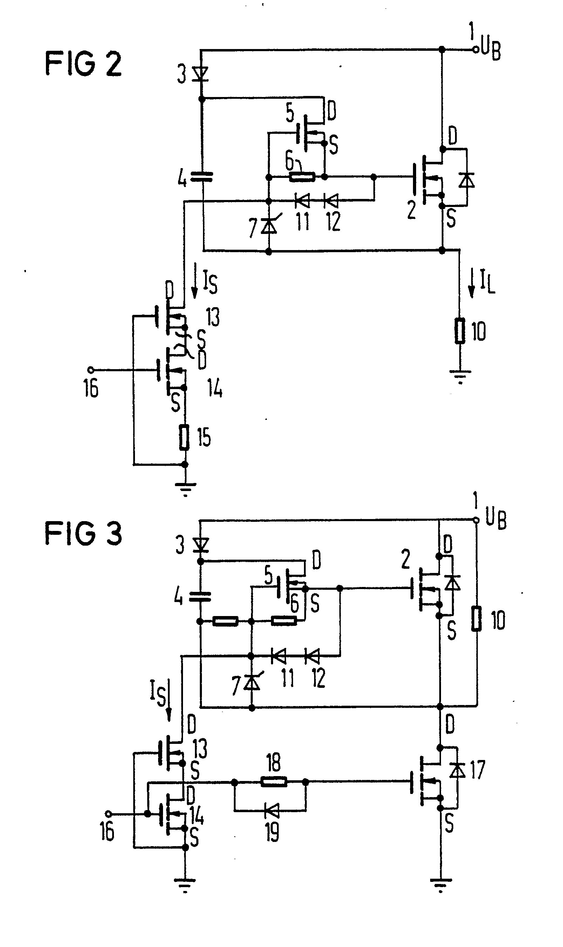

FIG 2 zeigt eine Realisierungsmöglichkeit der Schaltungsanordnung nach FIG 1. Die Stromquelle (8 in FIG 1) ist durch einen zweiten Depletion-MOSFET 13 gebildet, dessen Gate-Anschluß mit Masse, und dessen Drain-Anschluß mit dem Gate-Anschluß des Transistors 5 verbunden ist. Der Schalter (9 in FIG 1) wird durch einen weiteren MOSFET 14 gebildet, dessen Drain-Anschluß mit dem Source-Anschluß des Transistors 13 und dessen Source-Anschluß über einen Widerstand 15 mit Masse verbunden ist. Der Gate-Anschluß des Transistors 14 ist mit einer Eingangsklemme 16 verbunden, an die beispielsweise das Ausgangssignal einer Logikschaltung mit den Pegeln L = 0V oder H = 5V angelegt werden kann.

Ist die Spannung an der Eingangsklemme 16 = H, so leitet der Transistor 14, und es fließt über die Drain-Source-Strecke des Transistors 13 ein Strom $I_S$, der die Gate-Source-Kapazität von Transistor 2 entlädt. Dieser Vorgang kann z.B. durch die Reihenschaltung zweier Dioden 11, 12 beschleunigt werden, die dem Widerstand 6 parallel geschaltet ist. Die Reihenschaltung dieser zwei Dioden sorgt durch den Spannungsabfall von ca. 1,2V für ein sicheres Sperren von Transistor 5. Die übrige Schaltungsanordnung entspricht in ihrer Funktion der in FIG 1 beschriebenen.

FIG 3 zeigt ein Ausführungsbeispiel als Halb-Brücke. Ein weiterer Leistungs-MOSFET 17 bildet zusammen mit dem Transistor 2 eine Halbbrücke, derart, daß der Drain-Anschluß von Transistor 17 mit dem Source-Anschluß vom Transistor 2 und der Source-Anschluß von Transistor 17 mit Masse verbunden ist. Der Gate-Anschluß von Transistor 17 ist über einen Widerstand 18 mit der Eingangsklemme 16 verbunden. Eine Diode 19 ist dem Widerstand 18 parallel geschaltet. Zwischen dem Source-Anschluß von Transistor 2 und dem Drain-Anschluß von Transistor 17 ist ein Mittelabgriff, der mit der Last 10 verbunden ist. Der andere Anschluß der Last 10 ist mit der Ausgangsklemme 1 verbunden.

Die Leistungstransistoren 2 und 17 werden im Gegentakt betrieben, wobei der Transistor 17 direkt von der an der Eingangsklemme 16 anliegenden Spannung und der Transistor 2, wie in FIG 1 beschrieben, über den Transistor 5 gesteuert wird. Die übrige Funktionsweise entspricht der in FIG 2 beschriebenen.

## Ansprüche

1. Schaltungsanordnung zum Ansteuern eines Enhancement-MOSFET, mit einer Last, die zwischen Source und einem vorgegebenen festen Potential liegt, mit den Merkmalen:

   a) der Drain-Anschluß des MOSFET (2) ist mit einer Ausgangsklemme (1) verbunden,

   b) zwischen dem Gate-Anschluß des MOSFET (2) und einem festen Potential liegt ein Schalter (9),

   c) zwischen der Ausgangsklemme (1) und dem Source-Anschluß des MOSFET (2) liegt die Reihenschaltung aus einer Diode (3) und einem Kondensator (4),

   d) die Reihenschaltung von Diode (3) und Kondensator (4) ist mit einem Mittelabgriff versehen, der über einen Transistor (5) mit dem Gate-Anschluß des MOSFET (2) verbunden ist,

   **gekennzeichnet durch** die Merkmale:

   e) zwischen Schalter (9) und Gate-Anschluß liegt eine Stromquelle (8),

   f) der Transistor (5) ist ein Depletion-MOSFET,

   g) zwischen Gate-Anschluß und Source-Anschluß des Depletion-MOSFET (5) liegen Mittel, an denen ein Spannungsabfall erzeugt wird.

2. Schaltungsanordnung nach Anspruch 1, **dadurch gekennzeichnet**, daß die Stromquelle (8) und der Schalter (9) durch die Reihenschaltung eines zweiten Depletion-MOSFET (13) mit einem zweiten Enhancement-MOSFET (14) gebildet werden, derart, daß der Gate-Anschluß des zweiten Depletion-MOSFET (13) mit Masse verbunden ist, daß der Source-Anschluß des zweiten Depletion-

MOSFET (13) mit dem Drain-Anschluß des zweiten Enhancement-MOSFET (14) verbunden ist, daß der Source-Anschluß des zweiten Enhancement-MOSFET (14) mit Masse verbunden ist, daß der Gate-Anschluß des zweiten Enhancement-MOSFET (14) an einer Eingangsklemme (16) liegt und daß der Drain-Anschluß des zweiten Depletion- MOSFET (13) mit dem Gate-Anschluß des ersten Depletion-MOSFET (5) verbunden ist.

3. Schaltungsanordnung nach Anspruch 2, **dadurch gekennzeichnet**, daß zwischen Source-Anschluß des zweiten Enhancement-MOSFET (14) und Masse ein Widerstand (15) liegt.

4. Schaltungsanordnung nach Anspruch 1, **dadurch gekennzeichnet**, daß die Mittel zur Erzeugung des Spannungsabfalls zwischen Gate-Anschluß und Source-Anschluß des Depletion-MOSFET (5) durch einen Widerstand (6) gebildet sind.

5. Schaltungsanordnung nach Anspruch 1, **dadurch gekennzeichnet**, daß die Mittel zur Erzeugung des Spannungsabfalls zwischen Gate-Anschluß und Source-Anschluß des Depletion-MOSFET (5) durch zwei in Reihe geschaltete Dioden (11, 12) gebildet sind.

6. Schaltungsanordnung nach Anspruch 1, **dadurch gekennzeichnet**, daß zwischen dem Gate-Anschluß des Depletion-MOSFET (5) und dem Source-Anschluß des Enhancement-MOSFET eine Zenerdiode (7) liegt.

# FIG 1

FIG 2

FIG 3